# EUROPEAN PATENT SPECIFICATION

(11) **EP 0 302 641 B1**
(45) Date of publication and mention of the grant of the patent: **20.10.1993**
(21) Application number: 88306812.4
(22) Date of filing: 25.07.1988
(51) Int. Cl.: H01L 23/42, H01L 23/46

(54) **Cooling structure for heat generating electronic components mounted on a substrate**
Kühlungsstruktur für auf einem Substrat montierte elektronische Wärmeerzeugende Bauelemente
Structure de refroidissement pour des composants électroniques produisant de la chaleur, qui sont montés sur un substrat

(30) Priority: 24.07.1987 JP 185182/87; 29.07.1987 JP 189201/87; 19.08.1987 JP 204168/87; 15.10.1987 JP 157800/87 U
(43) Date of publication of application: 08.02.1989
(73) Proprietor: NEC CORPORATION, Tokyo (JP)
(72) Inventor: Mine, Shinji c/o NEC Corporation, Minato-ku Tokyo (JP); Shimonishi, Terumi c/o NEC Corporation, Minato-ku Tokyo (JP)
(74) Representative: Abnett, Richard Charles

(56) References cited:
- FR-A- 2 569 306
- US-A- 3 405 323
- IEEE TRANSACTIONS ON COMPONENTS, HYBRIDS, AND MANUFACTURING TECHNOLOGY, vol. CHMT-10, no. 2, June 1987, pages 159-175, IEEE, New York, NY., US; A.BAR-COHEN: "Thermal management of air- and liquid-cooled multichip modules"
- PATENT ABSTRACTS OF JAPAN, vol. 12, no. 72 (E-588)[2919], 5th March 1988 & JP-A-62 214 651 (NEC CORP.) 21-09-1987

## Description

### Background of the Invention

The invention relates to a cooling structure for heat generating electronic components, such as integrated circuit (IC) chips.

U.S. Patent US-A-3 405 323 and our U.S. Patent US-A-4 628 990 (= FR-A-2 569 306) disclose examples of prior art cooling structures for IC chips. The present invention is concerned with improvements in the cooling structures of these prior patents.

### Summary of the Invention

The invention is defined in claim 1 below to which reference should now be made. Advantageous features of the invention are defined in the sub-claims.

### Brief Description of the Drawings:

The invention will now be described by way of example, in the following detailed description when taken in conjunction with the accompanying drawings, in which:
Fig. 1 shows a perspective view with a partially exploded section of an embodiment of the invention;
Fig. 2 shows a cross-sectional view of the embodiment; and
Figs. 3A and 3B are plan and side views, respectively, of a piston used in the embodiment.

### Detailed Description of the Preferred Embodiment

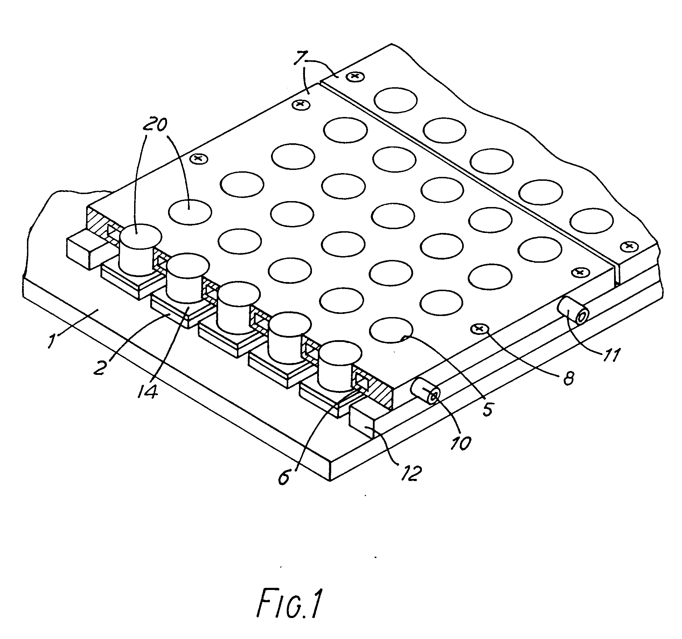

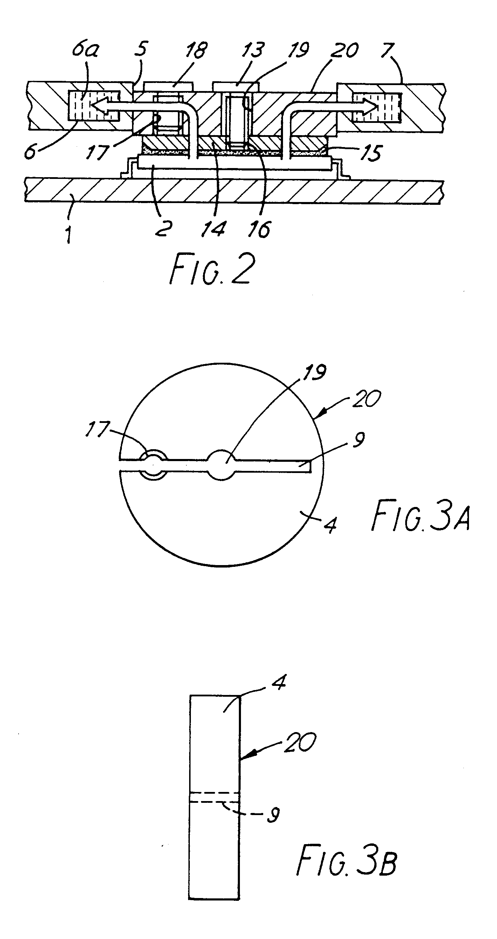

The embodiment shown in Figs. 1 and 2 comprises a substrate 1, IC chips 2 mounted on the substrate 1, heat-conductive plates 14 of metal attached on the upper surfaces of the chips 2 with an adhesive agent 15, pistons 20 in contact with the plates 14, and a cold plate 7 having flow paths 6 and a plurality of holes 5 for insertion of the pistons 20. The plate 7 cools the pistons 20 inserted in the holes 5 with a coolant 6a circulating through the flow paths 6. The heat generated from each chip 2 is transmitted through a path, shown by a broad arrow in Fig 2, extending from the adhesive agent 15 via the plate 14, the piston 20 and the plate 7 to the coolant 6a.

The plate 7 is provided with an inlet 10 and an output 11 for the coolant 6a on one side thereof. The plate 7 is spaced from the substrate 1 by a predetermined distance by stiffeners 12. The plate 7, the stiffeners 12 and the substrate 1 are fixed with screws 8. The plate 7 may be made integrally with the stiffeners 12.

Referring to Figs 3A and 3B, each of the pistons 20 has a longitudinal slit 9 extending through the centre of the piston, a through hole 19 at the centre of the piston, and a threaded screw hole 17 extending through the slit near the through hole 19 and to the side of the through hole which is towards the open end of the slit, as shown. The pistons 20 are inserted into the holes 5 of the cold plate 7 to come into contact with the upper surfaces of the plates 14, respectively. First threaded screws 13 are driven into the through holes 19 of the pistons 20 to be engaged with threaded screw holes 16 formed in the heat conductive plates 14, until flanges formed at the tops of the screws 13 abut against the upper surfaces of the pistons 20, respectively. This fixes the pistons 20 on the plates 14. Then second threaded screws 18 are mated with the screw holes 17 of the pistons 20. By tightening the screws 18 in the screw holes 17, the slits on the pistons 20 are expanded to fix the pistons 20 snugly in the holes 5 of the cold plate 7 through friction.

## Claims

1. A cooling structure for heat-generating electronic components (2) mounted on a substrate (1), comprising:
a cold plate (7) fixed on said substrate, which cold plate is provided with first through holes (5) aligned with the upper surfaces of the heat-generating electronic components on said substrate;
flow paths (6) formed within said cold plate for circulation of coolant;
an inlet (10) provided on a side of said cold plate for supplying said coolant into said flow paths;
an outlet (11) provided on a side of said cold plate for exhausting said coolant from said flow paths;
pistons (20) inserted through and held within said first through holes; and
an intermediary member (14) made of a heat-conductive material interposed between each of said lower surfaces of said pistons and a corresponding one of the upper surfaces of the electronic components to provide a heat-conducting path therebetween, said intermediary member having a first threaded hole (16); and
each of said pistons including:
a longitudinal slit (9);
a second through hole (19) provided at the centre of the piston;
a first screw (13) inserted through said second through hole (19) to be engaged with said first threaded hole (16);
a second threaded hole (17) formed within said slit at a position near said second through hole; and
a second screw (18) inserted into said second threaded hole (17) so as to expand said slit for causing the wall surface of the first through hole (5) in which the piston (20) is inserted to come into contact with the outer surface of the piston.

2. A cooling structure as claimed in Claim 1, wherein said pistons are cylindrical.

3. A cooling structure as claimed in Claim 1 or 2, wherein said heat-conductive material is metal.

4. A cooling structure as claimed in claim 3, wherein said intermediary member (14) is attached to the upper surfaces of the heat-generating electronic components by an adhesive agent (15).

5. A cooling structure as claimed in any preceding claim, wherein said longitudinal slit (9) extends through the centre of the piston (20).

## Patentansprüche

1. Kühlungsstruktur für auf einem Substrat (1) montierte wärmeerzeugende elektronische Bauelemente (2) mit:
einer auf dem Substrat befestigten kalten Platte (7), wobei die kalte Platte mit ersten Durchgangslöchern (5) versehen ist, die mit den oberen Flächen der wärmeerzeugenden elektronischen Bauelemente auf dem Substrat ausgerichtet sind,
Fließwegen (6), die innerhalb der kalten Platte für eine Zirkulation eines Kühlmittels ausgebildet sind,
einem Einlaß (10), der an einer Seite der kalten Platte vorgesehen ist, zum Zuführen des Kühlmittels in die Fließwege,
einem Auslaß (11), der auf einer Seite der kalten Platte vorgesehen ist, zum Abgeben des Kühlmittels von den Fließwegen,
Kolben (20), die durch die ersten Durchgangslöcher eingesetzt und darin gehalten werden, und
einem aus einem wärmeleitenden Material bestehenden Zwischenelement (14), das zwischen jeder der unteren Flächen der Kolben und einer entsprechenden der oberen Flächen der elektronischen Bauelemente angeordnet ist, so daß ein wärmeleitender Weg zwischen diesen bereitgestellt wird, wobei das Zwischenelement ein erstes Gewindeloch (16) aufweist und jeder der Kolben aufweist:
einen Längsschlitz (9),
ein zweites Durchgangsloch (19), das in der Mitte des Kolbens vorgesehen ist,
eine erste Schraube (13), die durch das zweite Durchgangsloch (19) eingesetzt und mit dem ersten Gewindeloch (16) in Eingriff gebracht wird;
ein zweites Gewindeloch (17), das in dem Schlitz ausgebildet ist an einer Stelle benachbart zu dem zweiten Durchgangsloch, und
eine zweite Schraube (18), die in das zweite Gewindeloch (17) eingesetzt wird, so daß der Schlitz geweitet wird, wodurch die Wandfläche des ersten Durchgangslochs (5), in das der Kolben (20) eingesetzt ist, mit der Außenfläche des Kolbens in Berührung kommt.

2. Kühlungsstruktur nach Anspruch 1, wobei die Kolben zylindrisch sind.

3. Kühlungsstruktur nach Anspruch 1 oder 2, wobei das wärmeleitende Material Metall ist.

4. Kühlungsstruktur nach Anspruch 3, wobei das Zwischenelement (14) an den oberen Flächen der wärmeerzeugenden elektronischen Bauelemente mittels eines Klebmittels (15) angebracht ist.

5. Kühlungsstruktur nach einem der vorstehenden Ansprüche, wobei der Längsschlitz (9) sich durch die Mitte des Kolbens (20) erstreckt.

## Revendications

1. Structure de refroidissement pour composants électroniques produisant de la chaleur (2) montés sur un substrat (1), comprenant :
une plaque de refroidissement (7) fixée sur le substrat, laquelle plaque de refroidissement est prévue avec des premiers trous de passage (5) alignés avec les surfaces supérieures des composants électroniques produisant de la chaleur sur le substrat ;
des trajets d'écoulement (6) formés à l'intérieur de la plaque de refroidissement pour circulation d'un agent de refroidissement ;
un orifice d'entrée (10) prévu sur un côté de la plaque de refroidissement pour délivrer l'agent de refroidissement dans les trajets d'écoulement ;
un orifice de sortie (11) prévu sur un côté de la plaque de refroidissement pour évacuer l'agent de refroidissement des trajets d'écoulement ;
des pistons (20) insérés dans et maintenus à l'intérieur des premiers trous de passage, et
un élément intermédiaire (14) constitué d'un matériau conducteur de la chaleur interposé entre chacune des surfaces inférieures des pistons et une surface supérieure correspondante des surfaces supérieures de composants électroniques pour procurer un trajet conducteur de la chaleur entre ceux-ci, ledit élément intermédiaire ayant un premier trou taraudé (16), et
chacun des pistons comportant :
une fente longitudinale (9) ;
un second trou de passage (19) prévu au centre du piston ;
une première vis (13) insérée dans le second trou de passage (19) pour être vissée dans le premier trou taraudé (16) ;
un second trou taraudé (17) formé à l'intérieur de la fente à une position près du second trou de passage, et
une seconde vis (18) insérée dans le second trou taraudé (17) de façon à dilater la fente pour amener la surface de paroi du premier trou de passage (5) dans lequel le piston (20) est inséré à venir en contact avec la surface extérieure du piston.

2. Structure de refroidissement selon la revendication 1, dans laquelle les pistons sont cylindriques.

3. Structure de refroidissement selon la revendication 1 ou 2, dans laquelle le matériau conducteur de la chaleur est un métal.

4. Structure de refroidissement selon la revendication 3, dans laquelle l'élément intermédiaire (14) est fixé aux surfaces supérieures des composants électroniques produisant de la chaleur par un agent adhésif (15).

5. Structure de refroidissement selon l'une quelconque des revendications précédentes, dans laquelle la fente longitudinale (9) part à partir du centre du piston (20).
